(19) **Europäisches Patentamt / European Patent Office / Office européen des brevets**

(11) **EP 4 738 307 A1**

(12) **EUROPEAN PATENT APPLICATION**

(43) Date of publication:
06.05.2026 Bulletin 2026/19

(21) Application number: 25211261.0

(22) Date of filing: 27.10.2025

(51) International Patent Classification (IPC):
*G08G 1/01* (2006.01)

(52) Cooperative Patent Classification (CPC):
G08G 1/0141; G08G 1/0112; G08G 1/0129;
G08G 1/0133; G08G 1/015

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: 31.10.2024 KR 20240152553

(71) Applicant: **Morai Inc.**
Seoul 06168 (KR)

(72) Inventors:
• **JUNG, Mi Na**
06168 Seoul (KR)
• **JEON, Seung Min**
06168 Seoul (KR)
• **JUNG, Heewon**
06168 Seoul (KR)
• **JEON, Hyeong Seok**
Seoul 06168 (KR)

(74) Representative: **Studio Torta S.p.A.**
Via Viotti, 9
10121 Torino (IT)

(54) **METHOD AND ELECTRONIC DEVICE FOR PROVIDING TRAFFIC FLOW SIMULATION INFORMATION USING VEHICLE TYPE-SPECIFIC TRAFFIC VOLUME DATA**

(57) A traffic flow simulation method includes acquiring road map data including information regarding each of one or more lanes included in a road, acquiring traffic flow data corresponding to the road, acquiring road infrastructure data corresponding to the road, acquiring vehicle terminal data from at least one vehicle located on the road, and generating simulation information regarding the road, based on at least one of the road map data, the road infrastructure data, traffic volume information by vehicle type included in the traffic flow data, and the vehicle terminal data.

FIG. 12

## Description

### FIELD

The present disclosure relates to a method and an electronic device for providing traffic flow simulation information using vehicle type-specific traffic volume information.

### BACKGROUND

Autonomous driving technology refers to a technology that can autonomously drive a vehicle with minimal human intervention or without human intervention by recognizing the surrounding environment using radar, LIDAR (light detection and ranging), GPS, a camera, and the like. Since a real driving environment has various factors that affect autonomous driving, such as vehicles in a road area, traffic structures, and buildings in an area outside the road, a vast amount of testing is required to secure an autonomous driving function without human intervention.

Meanwhile, since there is a limit to autonomous driving tests in a real driving environment, there are many attempts to test autonomous driving by constructing a virtual environment corresponding to the real driving environment. However, there is a problem in that the current virtual environment for autonomous driving requires a lot of time and cost, such as a person directly refining and mapping data and performing 3D modeling. Due to such a problem, there are many limitations in constructing a virtual environment for testing an autonomous driving function or autonomous driving software under various conditions.

Therefore, a demand for constructing a virtual environment simulation that considers more realistic traffic situations is increasing.

### SUMMARY

The present disclosure provides a method and an electronic device for providing simulation information for solving the problems as described above.

The present disclosure may be implemented in various ways, including a method, an apparatus (system), and/or a non-transitory computer-readable recording medium storing computer-readable instructions.

In some embodiments, a traffic flow simulation method includes acquiring road map data including information regarding each of one or more lanes included in a road, acquiring traffic flow data corresponding to the road, acquiring road infrastructure data corresponding to the road, acquiring vehicle terminal data from at least one vehicle located on the road, and generating simulation information regarding the road, based on at least one of the road map data, the road infrastructure data, traffic volume information by vehicle type included in the traffic flow data, and the vehicle terminal data.

In some embodiments, the traffic flow simulation method may further include acquiring wheelbase distance or length information by vehicle type. The generating the simulation information is performed by considering the wheelbase distance or length information by vehicle type.

In some embodiments, the traffic flow simulation method may further include calculating an inter-vehicle distance based on the vehicle terminal data. The inter-vehicle distance is determined by considering an average distance for each vehicle type.

In some embodiments, the road infrastructure data may include signal phase and timing operation information and map data. The generating may include mapping the map data to the road map data and generating a road in a virtual environment, identifying a specific intersection existing on the road in the virtual environment, identifying the identified specific intersection in the signal phase and timing operation information, and applying a signal state of the specific intersection to the road in the virtual environment based on the signal phase and timing operation information.

In some embodiments, the signal phase and timing operation information may include a unique number of an intersection and a plurality of pieces of movement state information, the movement state information may include a signal group identifier, a plurality of signal states, and remaining time information until each of the signal states changes to a next signal state, the map data may include a unique number of an intersection, reference point information, and one or more pieces of lane information, the lane information may include offset point information determined based on the reference point information, a signal group identifier verifiable in a lane, lane information connected to the lane, and entry/exit attribute information of the lane, and the identifying the specific intersection may include matching map data having a same signal group identifier as a signal group identifier included in the signal phase and timing operation information.

In some embodiments, the generating may include placing a reference vehicle on the road in a virtual environment, determining a number of surrounding vehicles, excluding the reference vehicle, among all vehicles to be placed on the road, and distributing and placing the surrounding vehicles for each section on the road divided by the reference vehicle.

In some embodiments, the generating may further include determining a speed of the surrounding vehicles, excluding the reference vehicle, among all the vehicles to be placed on the road, the calculating the speed of the surrounding vehicles may include determining an average speed of the surrounding vehicles, excluding the reference vehicle, among all the vehicles.

In some embodiments, the distributing and placing the surrounding vehicles may include determining a ratio by vehicle type based on traffic volume information included in the traffic flow data, and distributing and placing the surrounding vehicles according to the calculated ratio.

In some embodiments, a non-transitory computer-readable recording medium storing computer-readable instructions that, when executed by at least one processor, cause the at least one processor to acquire road map data including information regarding each of one or more lanes included in a road, acquire traffic flow data corresponding to the road, acquire road infrastructure data corresponding to the road, acquire vehicle terminal data from at least one vehicle located on the road, and generate simulation information regarding the road, based on at least one of the road map data, the road infrastructure data, traffic volume information by vehicle type included in the traffic flow data, and the vehicle terminal data.

In some embodiments, an electronic device includes a memory, and at least one processor coupled to the memory and configured to execute at least one computer-readable instruction stored in the memory, wherein the at least one processor is configured to acquire road map data including information regarding each of one or more lanes included in a road, acquire traffic flow data corresponding to the road, acquire road infrastructure data corresponding to the road, acquire vehicle terminal data from at least one vehicle located on the road, and generate simulation information regarding the road, based on at least one of the road map data, the road infrastructure data, traffic volume information by vehicle type included in the traffic flow data, and the vehicle terminal data.

According to some embodiments of the present disclosure, by generating simulation information for a reference vehicle through real-time data provided by a C-ITS (Cooperative-Intelligent Transport Systems) terminal-equipped vehicle and generating surrounding vehicles based on the simulation information, it is possible to generate traffic flow simulation information that is more similar to realistic vehicle behavior.

In addition, according to some embodiments of the present disclosure, by generating simulation information in consideration of vehicle types, it is possible to generate simulation information that better reflects real information.

The effects of the present disclosure are not limited to the effects mentioned above, and other unmentioned effects will be clearly understood by those of ordinary skill in the art to which the present disclosure pertains (hereinafter referred to as 'a person of ordinary skill in the art') from the description of the claims.

## BRIEF DESCRIPTION OF THE DRAWINGS

Embodiments of the present disclosure will be described with reference to the accompanying drawings described below, in which like reference numerals denote like elements, but are not limited thereto.

FIG. 1 is a diagram illustrating a configuration of an electronic device for providing simulation information according to an embodiment of the present disclosure.

FIG. 2 is a schematic diagram illustrating a configuration in which an information processing system is communicably connected with a plurality of user terminals in relation to data processing according to an embodiment of the present disclosure.

FIG. 3 is a block diagram illustrating internal configurations of a user terminal and an information processing system according to an embodiment of the present disclosure.

FIG. 4 is a diagram for explaining traffic flow data according to an embodiment of the present disclosure.

FIG. 5 is a diagram for explaining traffic volume information by vehicle type associated with traffic flow data according to an embodiment of the present disclosure.

FIG. 6 is a diagram for explaining a classification standard and wheelbase distance information by vehicle type according to an embodiment of the present disclosure.

FIG. 7 is a conceptual diagram conceptually illustrating offset point information included in lane information according to an embodiment of the present disclosure.

FIG. 8 is an exemplary diagram visually illustrating simulation information in which a lane is implemented using lane information included in MAP data according to an embodiment of the present disclosure.

FIG. 9 is an exemplary diagram illustrating an inter-vehicle distance calculated in consideration of a type of vehicle according to an embodiment of the present disclosure.

FIG. 10 is an exemplary diagram illustrating intersection signal information generated by matching SPaT data and MAP data according to an embodiment of the present disclosure.

FIG. 11 is a conceptual diagram illustrating reference vehicle placement information placed on a road in a virtual environment according to an embodiment of the present disclosure.

FIG. 12 is a diagram for explaining a method of providing simulation information according to an embodiment of the present disclosure.

## DETAILED DESCRIPTION

Hereinafter, specific contents for carrying out the present disclosure will be described in detail with reference to the attached drawings. However, in the following description, when there is a concern that the gist of the present disclosure may be unnecessarily obscured, a detailed description of a widely known function or configuration will be omitted.

In the attached drawings, the same reference numerals are assigned to the same or corresponding components. Also, in the description of the following embodiments, a redundant description of the same or corresponding components may be omitted. However, even if the description of a component is omitted, it is not intended that such a component is not included in any embodiment.

Advantages and features of the disclosed embodiments and methods of achieving them will become clear with reference to the embodiments described below along with the attached drawings. However, the present disclosure is not limited to the embodiments disclosed below, but may be implemented in various different forms, and these embodiments are only provided to make the present disclosure complete and to fully inform the scope of the invention to a person of ordinary skill in the art.

The terms used in this specification will be briefly described, and the disclosed embodiments will be described in detail. The terms used in this specification were selected as general terms that are currently widely used as much as possible while considering the functions in the present disclosure, but the terms may vary depending on the intention of a technician engaged in the relevant field, or precedents, the emergence of new technologies, and the like. Also, in specific cases, there are terms arbitrarily selected by the applicant, and in this case, the meaning thereof will be described in detail in the description part of the corresponding invention. Therefore, the terms used in the present disclosure should be defined based on the meaning of the terms and the content throughout the present disclosure, not simply the names of the terms.

In this specification, a singular expression includes a plural expression unless the context clearly specifies that the expression is singular. Also, a plural expression includes a singular expression unless the context clearly specifies that the expression is plural. Throughout the specification, when a certain part is said to include a certain component, it means that the certain part may further include another component, not excluding the other component, unless there is a specific statement to the contrary.

In addition, the term 'module' or 'unit' as used in the specification means a software or hardware component, and the 'module' or 'unit' performs certain roles. However, the 'module' or 'unit' is not limited in meaning to software or hardware. A 'module' or 'unit' may be configured to be in an addressable storage medium and may be configured to reproduce one or more processors. Therefore, as an example, a 'module' or 'unit' may include at least one of components such as software components, object-oriented software components, class components, and task components, and processes, functions, attributes, procedures, subroutines, segments of program code, drivers, firmware, microcode, circuits, data, databases, data structures, tables, arrays, or variables. The function provided in the components and 'modules' or 'units' may be combined into a smaller number of components and 'modules' or 'units' or may be further separated into additional components and 'modules' or 'units'.

According to an embodiment of the present disclosure, a 'module' or a 'unit' may be implemented as a processor and a memory. A 'processor' should be broadly interpreted to include a general-purpose processor, a central processing unit (CPU), a microprocessor, a digital signal processor (DSP), a controller, a microcontroller, a state machine, and the like. In some circumstances, a 'processor' may refer to an application-specific integrated circuit (ASIC), a programmable logic device (PLD), a field programmable gate array (FPGA), and the like. A 'processor' may refer to a combination of processing devices, such as, for example, a combination of a DSP and a microprocessor, a combination of a plurality of microprocessors, a combination of one or more microprocessors coupled with a DSP core, or a combination of any other such configurations. Also, a 'memory' should be broadly interpreted to include any electronic component capable of storing electronic information. A 'memory' may refer to various types of processor-readable media such as random access memory (RAM), read-only memory (ROM), non-volatile random access memory (NVRAM), programmable read-only memory (PROM), erasable-programmable read-only memory (EPROM), electrically erasable PROM (EEPROM), flash memory, magnetic or marking data storage devices, registers, and the like. A memory is said to be in electronic communication with a processor if the processor can read information from and/or write information to the memory. A memory integrated into a processor is in electronic communication with the processor.

In addition, terms such as first, second, A, B, (a), (b), etc. used in the following embodiments are used only to distinguish one component from another, and the essence, order, or sequence of the corresponding component is not limited by the term.

In addition, in the following embodiments, when it is described that a certain component is 'connected' or 'coupled' to another component, the component may be directly connected or accessed to the other component, but it should be understood that another component may be 'connected' or 'coupled' between each component.

In addition, 'comprises' and/or 'comprising' used in the following embodiments do not exclude the presence or addition of one or more other components, steps, operations and/or elements to the mentioned components, steps, operations and/or elements.

Hereinafter, various embodiments of the present disclosure will be described in detail with reference to the attached drawings.

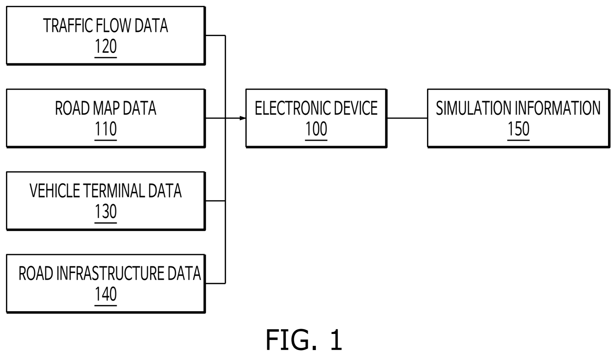

FIG. 1 is a diagram for explaining a configuration of an electronic device 100 for providing simulation information 150 according to an embodiment of the present disclosure. Referring to FIG. 1, an electronic device 100 may generate simulation information 150 indicating a traffic situation of a road, based on road map data 110, traffic flow data 120 of the road, vehicle terminal data 130, and/or road infrastructure data 140. Here, the road map data 110 may include data (e.g., vector data) in which each of a plurality of lanes included in a road is represented by a node and a link connected from the node. The road map data 110 may, for example, include road map data distributed by the National Geographic Information Institute (NGII). In addition, the traffic flow data 120 may be a continuous value such as the number of passing vehicles per unit time, an average speed of vehicles, traffic volume, and density, or a combination thereof. In addition, the traffic flow data 120 may further include discrete values of three stages: smooth, slow, and congested. In an example, the vehicle terminal data 130 may refer to data received from a vehicle equipped with a C-ITS terminal. In an example, the road infrastructure data 140 may include SPaT data, MAP data, RSA data, and TIM data.

In the present disclosure, simulation information 150 refers to information converted into a state in which numerical data given from the outside can be used (e.g., visualized) in a simulator, and the term "simulate" may mean that it can be used (e.g., visualized) in a simulator by combining or calculating various numerical data.

The electronic device 100 for providing the simulation information 150 may include a memory and a processor. However, the configuration of the electronic device 100 is not limited thereto. According to various embodiments, the electronic device 100 may further include at least one other component in addition to the above-described components. For example, the electronic device 100 may further include a communication circuit for receiving various data from an external device.

The memory may store various data used by at least one component (e.g., a processor) of the electronic device 100. The data may include, for example, input data or output data for software (or a program) and instructions related thereto. The memory may include a volatile memory or a non-volatile memory.

The processor may be connected to the memory and configured to execute at least one computer-readable program included in the memory. For example, the processor may execute software (or a program) to control at least one other component (e.g., a hardware or software component) of the electronic device 100 connected to the processor, and may perform various data processing or operations. According to an embodiment, as at least a part of data processing or operations, the processor may load an instruction or data received from another component (e.g., a communication circuit) into a volatile memory, process the instruction or data stored in the volatile memory, and store resulting data in a non-volatile memory.

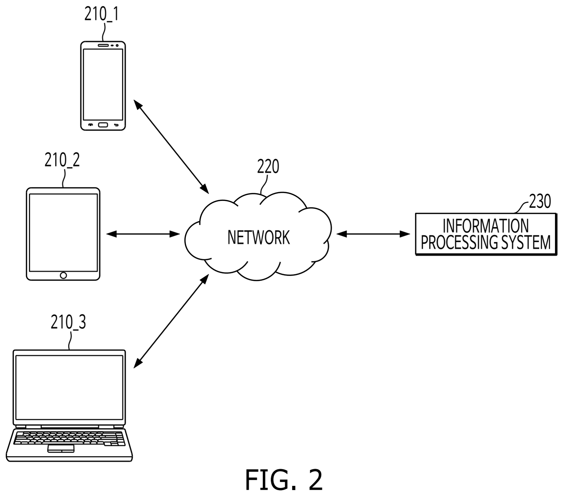

FIG. 2 is a schematic diagram illustrating a configuration in which an information processing system 230 is communicably connected with a plurality of user terminals 210_1, 210_2, and 210_3 in relation to data processing according to an embodiment of the present disclosure. The information processing system 230 may include a system(s) that can provide a data processing service (e.g., a lane-specific congestion information service). In an embodiment, the information processing system 230 may include one or more server devices and/or databases that can store, provide, and execute a computer-executable program (e.g., a downloadable application) and data related to a data processing service, or one or more distributed computing devices and/or distributed databases based on a cloud computing service. For example, the information processing system 230 may include separate systems (e.g., servers) for a data processing service.

A data processing service, etc. provided by the information processing system 230 may be provided to a user through a data processing application, a web browser application, etc. installed in each of the plurality of user terminals 210_1, 210_2, and 210_3.

The plurality of user terminals 210_1, 210_2, and 210_3 may communicate with the information processing system 230 through a network 220. The network 220 may be configured to enable communication between the plurality of user terminals 210_1, 210_2, and 210_3 and the information processing system 230. The network 220 may be configured as a wired network such as Ethernet, a wired home network (Power Line Communication), a telephone line communication device, and RS-serial communication, a wireless network such as a mobile communication network, a Wireless LAN (WLAN), Wi-Fi, Bluetooth, and ZigBee, or a combination thereof, depending on an installation environment. A communication method is not limited, and may include not only a communication method utilizing a communication network that the network 220 may include (e.g., a mobile communication network, a wired internet, a wireless internet, a broadcasting network, a satellite network, etc.) but also short-range wireless communication between the user terminals 210_1, 210_2, and 210_3.

For example, the plurality of user terminals 210_1, 210_2, and 210_3 may transmit a data processing request, and an instruction associated with a user request for data processing to the information processing system 230 through the network 220, and the information processing system 230 may receive the data processing request and the instruction.

In FIG. 2, a mobile phone terminal 210_1, a tablet terminal 210_2, and a PC terminal 210_3 are illustrated as examples of a user terminal, but the present disclosure is not limited thereto, and the user terminals 210_1, 210_2, and 210_3 may be any computing device capable of wired and/or wireless communication and in which a data processing application or the like can be installed and executed. For example, a user terminal may include a smartphone, a mobile phone, a navigation system, a computer, a laptop, a digital broadcasting terminal, a Personal Digital Assistant (PDA), a Portable Multimedia Player (PMP), a tablet PC, a game console, a wearable device, an Internet of Things (IoT) device, a virtual reality (VR) device, an augmented reality (AR) device, and the like. In addition, although FIG. 2 illustrates that three user terminals 210_1, 210_2, and 210_3 communicate with the information processing system 230 through the network 220, the present disclosure is not limited thereto, and a different number of user terminals may be configured to communicate with the information processing system 230 through the network 220.

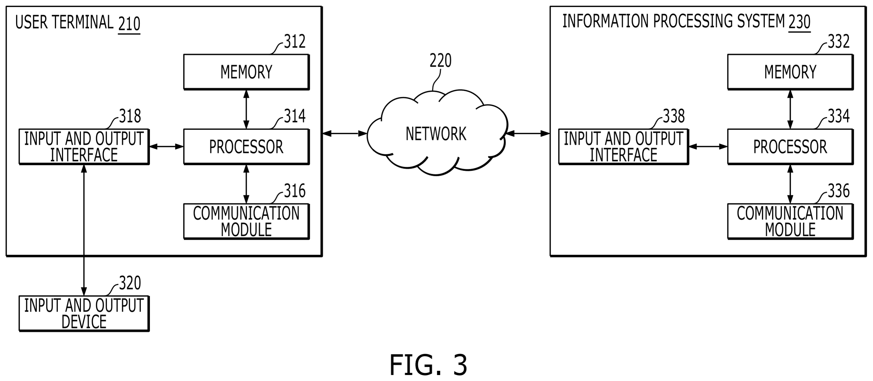

FIG. 3 is a block diagram illustrating internal configurations of a user terminal 210 and an information processing system 230 according to an embodiment of the present disclosure. The user terminal 210 may refer to any computing device in which a data processing application or the like can be executed and which is capable of wired/wireless communication, and may include, for example, the mobile phone terminal 210_1, the tablet terminal 210_2, the PC terminal 210_3, etc. of FIG. 2. As illustrated, the user terminal 210 may include a memory 312, a processor 314, a communication module 316, and an input/output interface 318. Similarly, the information processing system 230 may include a memory 332, a processor 334, a communication module 336, and an input/output interface 338. As illustrated in FIG. 3, the user terminal 210 and the information processing system 230 may be configured to communicate information and/or data through the network 220 using respective communication modules 316 and 336. In addition, an input/output device 320 may be configured to input information and/or data to the user terminal 210 through the input/output interface 318 or to output information and/or data generated from the user terminal 210.

The memories 312 and 332 may include any non-transitory computer-readable recording medium. According to an embodiment, the memories 312 and 332 may include a non-volatile mass storage device such as a read only memory (ROM), a disk drive, a solid state drive (SSD), a flash memory, and the like. As another example, a non-volatile mass storage device such as a ROM, an SSD, a flash memory, a disk drive, etc. may be included in the user terminal 210 or the information processing system 230 as a separate permanent storage device distinguished from the memory. In addition, an operating system and at least one program code (e.g., code for an application associated with a data processing service) may be stored in the memories 312 and 332.

These software components may be loaded from a computer-readable recording medium separate from the memories 312 and 332. Such a separate computer-readable recording medium may include a recording medium that can be directly connected to the user terminal 210 and the information processing system 230, and may include, for example, a computer-readable recording medium such as a floppy drive, a disk, a tape, a DVD/CD-ROM drive, a memory card, and the like. As another example, the software components may be loaded into the memories 312 and 332 through the communication modules 316 and 336, not a computer-readable recording medium. For example, at least one program may be loaded into the memories 312 and 332 based on a computer program (e.g., an application associated with a data processing service, etc.) installed by files provided through the network 220 by developers or a file distribution system that distributes installation files of an application.

The processors 314 and 334 may be configured to process instructions of a computer program by performing basic arithmetic, logic, and input/output operations. Instructions may be provided to the processors 314 and 334 by the memories 312 and 332 or the communication modules 316 and 336. For example, the processors 314 and 334 may be configured to execute received instructions according to program code stored in a recording device such as the memories 312 and 332.

The communication modules 316 and 336 may provide a configuration or function for the user terminal 210 and the information processing system 230 to communicate with each other through the network 220, and may provide a configuration or function for the user terminal 210 and/or the information processing system 230 to communicate with another user terminal or another system (e.g., a separate cloud system, etc.). As an example, a request or data (e.g., a data processing request or data, etc.) generated by the processor 314 of the user terminal 210 according to program code stored in a recording device such as the memory 312 may be delivered to the information processing system 230 through the network 220 under the control of the communication module 316. Conversely, a control signal or an instruction provided under the control of the processor 334 of the information processing system 230 may be received by the user terminal 210 through the communication module 316 of the user terminal 210 via the communication module 336 and the network 220.

The input/output interface 318 may be a means for an interface with the input/output device 320. As an example, an input device may include a device such as a camera including an audio sensor and/or an image sensor, a keyboard, a microphone, and a mouse, and an output device may include a device such as a display, a speaker, and a haptic feedback device. As another example, the input/output interface 318 may be a means for an interface with a device in which a configuration or function for performing input and output, such as a touch screen, is integrated into one. Although FIG. 3 illustrates that the input/output device 320 is not included in the user terminal 210, the present disclosure is not limited thereto, and the input/output device 320 may be configured as a single device with the user terminal 210. In addition, the input/output interface 338 of the information processing system 230 may be a means for an interface with a device (not illustrated) for input or output that is connected to or may be included in the information processing system 230. Although FIG. 3 illustrates that the input/output interfaces 318 and 338 are elements configured separately from the processors 314 and 334, the present disclosure is not limited thereto, and the input/output interfaces 318 and 338 may be configured to be included in the processors 314 and 334.

The user terminal 210 and the information processing system 230 may include more components than the components of FIG. 3. However, it is not necessary to clearly illustrate most conventional technical components. In an embodiment, the user terminal 210 may be implemented to include at least a part of the above-described input/output device 320. In addition, the user terminal 210 may further include other components such as a transceiver, a Global Positioning System (GPS) module, a camera, various sensors, a database, and the like. For example, if the user terminal 210 is a smartphone, the user terminal 210 may include components that a smartphone generally includes, and for example, various components such as an acceleration sensor, a gyro sensor, a microphone module, a camera module, various physical buttons, buttons using a touch panel, input/output ports, a vibrator for vibration, and the like may be implemented to be further included in the user terminal 210.

According to an embodiment, the processor 314 of the user terminal 210 may be configured to operate a data processing application or a web browser application that provides a data processing service. At this time, program code associated with the corresponding application may be loaded into the memory 312 of the user terminal 210. While the application is operating, the processor 314 of the user terminal 210 may receive information and/or data provided from the input/output device 320 through the input/output interface 318 or may receive information and/or data from the information processing system 230 through the communication module 316, and may process the received information and/or data and store the received information and/or data in the memory 312. In addition, such information and/or data may be provided to the information processing system 230 through the communication module 316.

While the data processing application is operating, the processor 314 may receive voice data, text, an image, a video, etc. input or selected through an input device such as a touch screen, a keyboard, a camera including an audio sensor and/or an image sensor, and a microphone connected to the input/output interface 318, and may store the received voice data, text, image, and/or video in the memory 312 or provide the received voice data, text, image, and/or video to the information processing system 230 through the communication module 316 and the network 220. In an embodiment, the processor 314 may receive a user input through an input device, and may provide data/a request corresponding to the received user input to the information processing system 230 through the network 220 and the communication module 316.

The processor 314 of the user terminal 210 may transmit information and/or data to the input/output device 320 through the input/output interface 318 to output the information and/or data. For example, the processor 314 of the user terminal 210 may output processed information and/or data through an output device 320 such as a display output-capable device (e.g., a touch screen, a display, etc.) and a voice output-capable device (e.g., a speaker).

The processor 334 of the information processing system 230 may be configured to manage, process, and/or store information and/or data received from a plurality of user terminals 210 and/or a plurality of external systems. Information and/or data processed by the processor 334 may be provided to the user terminal 210 through the communication module 336 and the network 220.

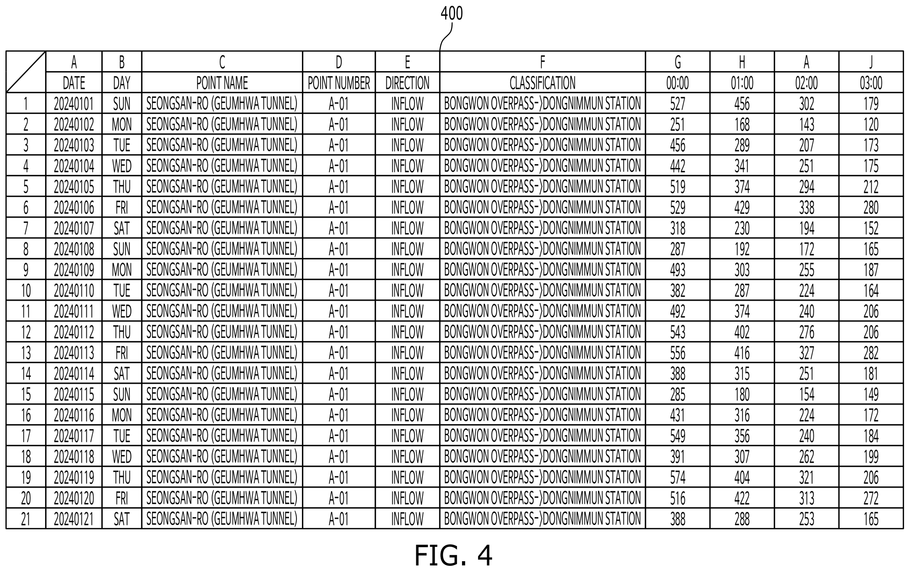

FIG. 4 is a diagram for explaining traffic flow data 400 according to an embodiment of the present disclosure. Referring to FIG. 4, traffic flow data 400 (e.g., the traffic flow data 120 of FIG. 1) used to generate simulation information (e.g., the simulation information 150 of FIG. 1) may be a continuous value such as the number of passing vehicles per unit time, an average speed of vehicles, traffic volume, and density, or a combination thereof. The traffic flow data 400 may include measurement time information, and may be real-time information or information for a specific period such as one day, one week, one month, or one year. A detector for measuring the traffic flow data 400 may be installed at a specific location on a road, and may include, for example, at least one of a loop detector, a magnetic detector, a WIM detector, a microwave detector, an infrared detector, an ultrasonic detector, or an image detector.

According to an embodiment, an open API provided by a traffic information system for each city/province or a server of the National Police Agency may be used to collect the traffic flow data 400 provided in real time. At this time, since the minimum unit provided by the API for the processing date and time of the traffic flow data 400 is seconds, a request may be made at 1-second intervals for real-time data collection. In addition, when data with the same processing date and time is received, the data may be determined as duplicate data, and the latest data may be periodically requested from the open API server until the next updated data is received.

According to an embodiment, when inquiring about the traffic flow data 400 based on a specific date, there is a method of using an Excel file or an open API that is the same as the real-time traffic flow data 400 as a form of data that can be provided. In this case, as illustrated in FIG. 4, data such as a point number, the total number of vehicles per time period, and traffic volume may be acquired.

The traffic flow data 400 may be generated through, for example, probe vehicle data (PVD) of a SAE J2735 message of a vehicle equipped with a C-ITS (cooperative-intelligent transport system) device, or may be acquired through a public data portal or a traffic information system for each city/province. A method of acquiring through a public data portal may include, for example, a method through a Seoul Metropolitan City bus location information inquiry service, a Gwangju Metropolitan City Gwangju C-ITS data inquiry service, and the like, and a method of acquiring through a traffic information system for each city/province may include, for example, a method through traffic volume information through the Seoul Traffic Information System, real-time road traffic information in Seoul, and a method through the Jeju Special Self-Governing Province Traffic Information Center.

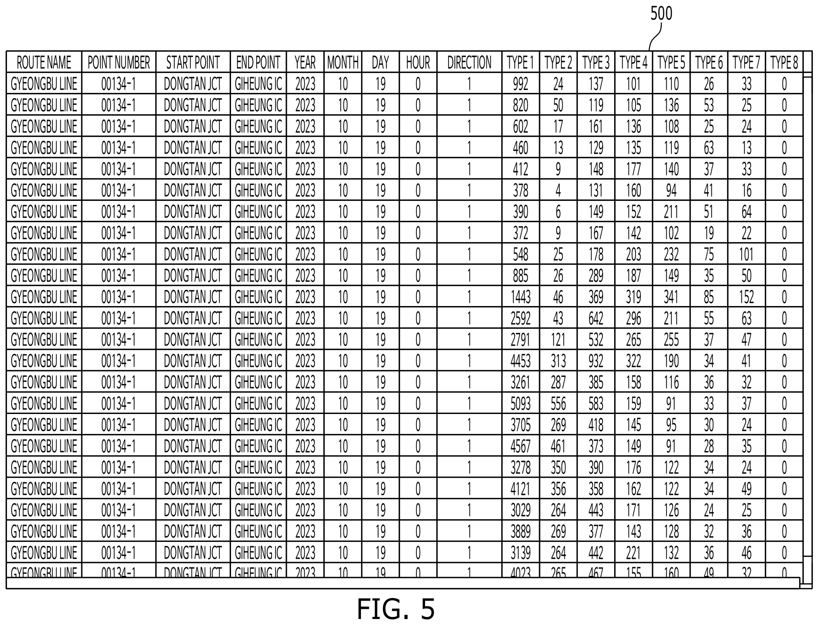

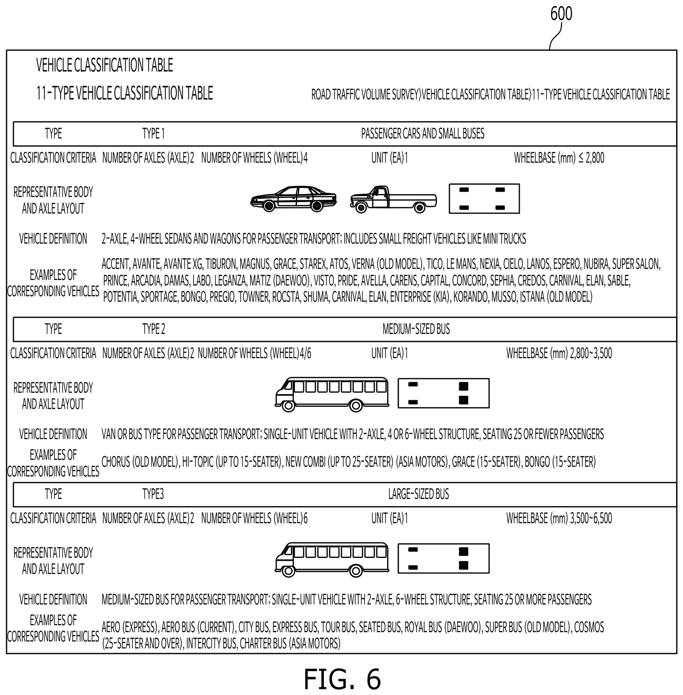

FIG. 5 is a diagram for explaining traffic volume information 500 by vehicle type associated with traffic flow data according to an embodiment of the present disclosure, and FIG. 6 is a diagram for explaining a classification standard and wheelbase distance information 600 by vehicle type according to an embodiment of the present disclosure. Referring to FIG. 5, the traffic volume information 500 by vehicle type may include a value regarding a vehicle type and a quantity of vehicles existing on each route on a road. Here, the classification of each vehicle type may be a classification according to the classification standard and wheelbase distance information 600 by vehicle type as illustrated in FIG. 6.

According to an embodiment, vehicle types may be classified into types 1 to 11 according to a classification standard announced by the Ministry of Land, Infrastructure and Transport, and each vehicle type may be classified through a standard according to the number of axles, the number of wheels, and the like. Each vehicle type may have a different wheelbase distance depending on the type. The wheelbase distance of a vehicle represents a distance between an axle of a front wheel and an axle of a rear wheel, and may be used to calculate a length of the vehicle.

The traffic volume information 500 by vehicle type and the wheelbase distance information 600 may be acquired through a public data portal or an announcement information provided by the government, and the electronic device 100 may acquire the corresponding information by receiving the corresponding information from an external database. In addition, the electronic device 100 may also acquire the traffic volume information 500 by vehicle type or the wheelbase distance information 600 by calling a public Application Programming Interface (API).

According to an embodiment, the present disclosure may refer to the 'Enforcement Rules of the Motor Vehicle Management Act' announced by the Ministry of Land, Infrastructure and Transport to calculate the length, width, and height of each vehicle type included in the traffic volume information 500 by vehicle type. The electronic device 100 may acquire length information according to each vehicle type from an external database by calling a public data API.

According to an embodiment of the present disclosure, the electronic device 100 for generating the simulation information 150 may acquire a captured image (e.g., a CCTV image) of a road from an external database. The electronic device 100 may acquire a captured image of a road by requesting an image in a streaming (HLS) type using a real-time transport protocol (RTP), a traffic information system for each city/province, or an open API on a server of the National Police Agency for real-time traffic volume analysis. In addition to this, any protocol that can be used for real-time streaming may be used. The captured image of the road may be acquired through, for example, a public data portal, the ITS National Traffic Information Center, the Urban Traffic Information Center of the National Police Agency, and the like.

Vehicle terminal data 130 according to an embodiment of the present disclosure may be used as a term referring to data received from a vehicle equipped with a C-ITS terminal. The vehicle terminal data 130 may include PVD data as J2735 standard data. PVD may refer to Probe Vehicle Data, and may include data associated with a driving state information of a vehicle. For example, the PVD may include a speed of a vehicle, a position of a vehicle, a brake pedal trajectory/angle value, a light system state, and the like.

According to an embodiment, the PVD data may include a vehicle type (vehicleType) and one or more snapshots. Here, a snapshot may be a value for collecting information about a vehicle between PVD data at a specific time point and PVD data at a next time point, in PVD data periodically generated according to a predetermined interval (e.g., 1 second). The PVD data may include a maximum of 32 snapshots, and through this, it is possible to acquire vehicle information collected at intervals of time shorter than an actual transmission period of PVD data transmitted from a vehicle. A snapshot may include a time when a corresponding snapshot value is acquired, position information of a vehicle, a safety-related event situation, and a vehicle state (wiper, vehicle exterior lights, GNSS, brake state). In addition, the PVD data may further include a J2540 ITIS code, vehicle type classification information of a traffic volume information providing system designated by the Ministry of Land, Infrastructure and Transport, and the like. Through the PVD data as described above, the electronic device 100 that generates the simulation information 150 may acquire the position, speed, and vehicle type information of each individual vehicle at a specific time point.

Road infrastructure data 140 according to an embodiment of the present disclosure may include SPaT data, MAP data, RSA data, and TIM data.

SPaT data of the present disclosure may refer to Signal Phase and Timing information, and may include state information of a signalized intersection transmitted from a signal controller at a specific time point. The SPaT data may include information about a plurality of intersections.

Intersection information included in the SPaT data may include a unique number (id) of an intersection, MinuteOfTheYear (moy) information indicating a time point when data about the corresponding intersection was acquired up to the minute, and timestamp information indicating a time point when data about the corresponding intersection was acquired up to the millisecond.

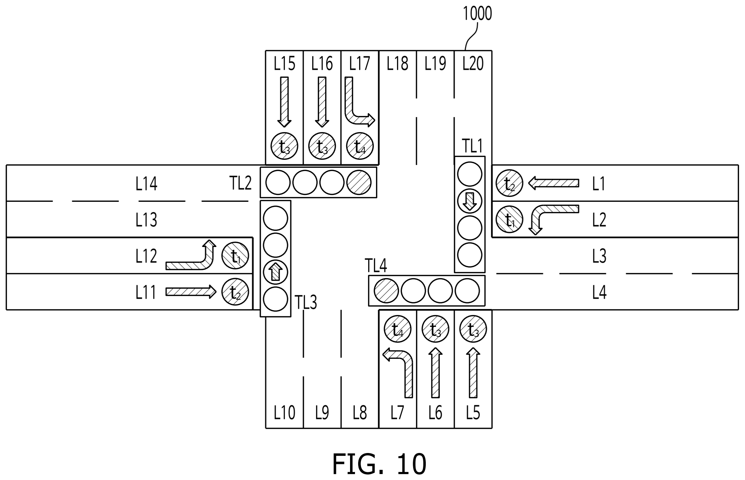

The SPaT data may include a plurality of pieces of MovementState information. Here, the movement state information may include a signal group identifier (signalGroup), a plurality of signal states, and remaining time information until each signal state changes to a next signal state. A signal state included in the movement state information may include values such as unavailable, dark, red or stop (reds), green or go (greens), and yellow or prepare (yellows). In addition, a signal state included in the movement state information may optionally include permissive/protected information. For example, a current signal state may be any one of stop-And-Remain / pre-Movement / permissive-Movement-Allowed / protected-Movement-Allowed. Here, MAP data to be described later includes a signal group identifier corresponding to each of a plurality of lanes included in a road, and thus by matching a common signal group identifier of the SPaT data and the MAP data, it is possible to calculate a signal state at a specific time point in a specific lane and a remaining time until the signal state changes to a next signal state. A method of matching the signal group identifiers of the SPaT data and the MAP data will be described in detail later with reference to FIG. 10.

MAP data of the present disclosure may refer to map data, and may include spatial data about a driving environment on a map. For example, the MAP data may include characteristics of a driving lane, intersection information, lane information, and the like. The MAP data provides topographical information, and may include information about a plurality of intersections in one message.

Intersection information included in the MAP data may include a name of an intersection, a unique number (id) of an intersection, reference point information (e.g., a center point of an intersection) (refPoint), and one or more pieces of lane information. At this time, the reference point information may include latitude and longitude coordinates of an intersection reference point.

Lane information included in the MAP data may include offset point information calculated based on the reference point information (refPoint), a signal group identifier that can be checked in a corresponding lane, lane information connected to the corresponding lane, and entry/exit attribute information of the corresponding lane.

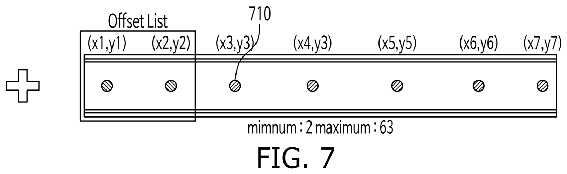

FIG. 7 is a conceptual diagram conceptually illustrating offset point information included in lane information according to an embodiment of the present disclosure. The offset point information may be composed of a list of at least 2 to a maximum of 63 offset points, and each offset point may include a coordinate value of the corresponding point. For example, reference numeral 710 indicates a third offset point included in specific lane information, and the electronic device 100 of the present disclosure can simulate a specific lane shape through data of this format.

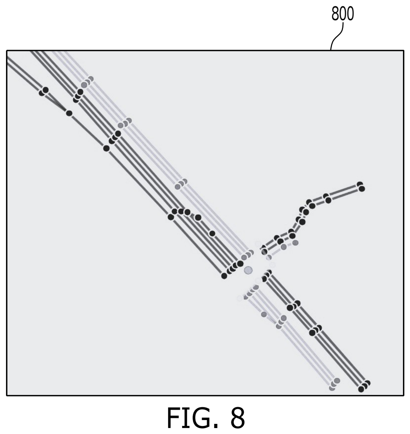

FIG. 8 is an exemplary diagram visually illustrating simulation information 800 in which a lane is implemented using lane information included in MAP data according to an embodiment of the present disclosure. The simulation information 800 in which a lane is implemented is information in which lane information about an intersection corresponding to reference point information (refPoint) expressed as a red dot is simulated, where a blue line indicates an entry lane of the corresponding intersection, and a green line indicates an exit lane of the corresponding intersection. At this time, blue dots and green dots indicate offset points of the corresponding lane.

RSA data may refer to Road Side Alert data, and may include obstacle factor information on a driving environment. Specifically, the RSA data may provide information on a dangerous situation on a road. For example, the RSA data may include information about an emergency vehicle and an emergency event. TypeEvent information included in the RSA data indicates not only classification of dangerous objects such as obstacles, fallen objects, and potholes, but also information on pedestrians, special vehicles, and the like through an ITIS code. In addition, position information included in the RSA data indicates information such as a position, a direction, and a speed at which a corresponding obstacle factor exists.

TIM data may be information that provides location-based traffic information or road work zone information. The TIM data includes topographical information (region) for designating a value for a road work zone as a range, and the topographical information may include a set of a plurality of latitude/longitude coordinates of a path of the road work zone or a zone radius based on a center point.

As described above, the electronic device 100 according to the present disclosure can effectively simulate a road state in a simulator by collecting various information received from an external database and expressing the various information on a road.

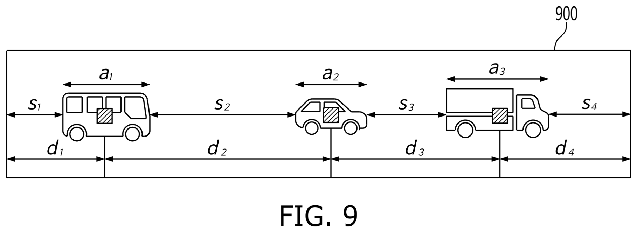

FIG. 9 is an exemplary diagram illustrating an inter-vehicle distance calculated in consideration of the type of vehicle according to an embodiment of the present disclosure. The electronic device 100 of the present disclosure may set a plurality of vehicle positions using latitude and longitude coordinates and time information of PVD data included in vehicle terminal data 130 generated in each vehicle. At this time, the electronic device 100 may determine a vehicle type of an individual vehicle in consideration of a vehicle type (vehicleType) included in the PVD data, and may predict a length of the vehicle according to the determined vehicle type. A vehicle length according to a vehicle type may be determined using vehicle type information included in the traffic flow data 120 as described above with reference to FIG. 6. At this time, assuming that a GPS measurement sensor that generates PVD data of each vehicle is installed in the center of each vehicle, the electronic device 100 may calculate an inter-vehicle distance (Spacing, S) using the latitude and longitude coordinates of the PVD data and an average length for each vehicle type, as in Equation 1 below.

Equation 1

$$s = d - (a_1 + a_2)/2$$

In Equation 1, s represents the inter-vehicle distance, d represents a distance according to a difference in latitude and longitude coordinates of two vehicles, $a_1$ represents an average length by vehicle type of one vehicle that is a target for inter-vehicle distance calculation, and $a_2$ represents an average length by vehicle type of another vehicle.

Next, the electronic device 100 may calculate a headway used for traffic volume calculation based on a moving speed of a vehicle and an inter-vehicle distance. At this time, the moving speed of the vehicle may be included in PVD data transmitted by each vehicle. For example, the electronic device may calculate a headway using Equation 2 below.

Equation 2

$$h = s/V$$

Here, h represents a headway, s represents the inter-vehicle distance described in Equation 1, and V represents a moving speed of a vehicle.

In addition, the electronic device may calculate a traffic volume and a density corresponding to the road map data based on the headway (h) and the inter-vehicle distance (s). For example, the electronic device may calculate a traffic volume for each lane using Equation 3 below, and may calculate a density for each lane using Equation 4 below.

Equation 3

$$q = 1/\bar{h}$$

Here, q represents a traffic volume for each lane, and h represents an average of headways for each lane.

Equation 4

$$k = 1/\bar{s}$$

Here, k represents a density for each lane, and $\bar{s}$ represents an average of inter-vehicle distances for each lane.

As described above, the electronic device 100 of the present disclosure can simulate a density of a lane and an average of inter-vehicle distances based on vehicle terminal data, and can further generate more precise simulation information by considering a type of vehicle.

FIG. 10 is an exemplary diagram illustrating intersection signal information generated by matching SPaT data and MAP data according to an embodiment of the present disclosure. The SPaT data and the MAP data each include time information and a signal group identifier, and the electronic device 100 may display various pieces of signal information as a single traffic light by matching and grouping the same signal group identifier at the same time included in the SPaT data and the MAP data. Specifically, the electronic device 100 identifies a lane entering a specific intersection by mapping the MAP data to the road map data 110. The MAP data includes intersection entry/exit information for each lane as described above. A traffic light displayed in a simulator may be displayed only for a lane entering a specific intersection. Then, the electronic device 100 matches a signal group identifier of the corresponding intersection included in the MAP data on the SPaT data, and may simulate a current signal state and a change of a signal by using a signal state of the corresponding intersection signal included in the SPaT data and remaining time information until the signal state changes to a next signal state. That is, the electronic device 100 draws a shape of a lane having a corresponding intersection entry attribute in the MAP data, maps the shape to a link of the road map data used in a simulator, and then may simulate a signal state and a next signal state that a specific lane should refer to by referring to a traffic light ID (i.e., a signal group identifier) of the intersection on the road map data in the SPaT data. According to the above description, for example, the left turn signal, which is a signal state referred to by lane L2 of FIG. 10, becomes a current signal state, and t2 represents a remaining time until the current signal state changes to a next signal state.

The electronic device 100 of the present disclosure may preferentially place a vehicle(s) equipped with a C-ITS terminal (hereinafter, also referred to as 'reference vehicle') on a road in a virtual environment based on vehicle terminal data 130, and then may additionally place a quantity of vehicles (hereinafter, also referred to as 'surrounding vehicles') corresponding to a difference between a traffic volume of the corresponding road according to traffic flow data and the number of reference vehicles placed on the road. Hereinafter, an embodiment of first spawning a reference vehicle in a virtual environment road using vehicle terminal data and then spawning surrounding vehicles using traffic flow data will be described in detail with reference to some equations.

First, the electronic device 100 places a reference vehicle in a virtual environment according to position information (latitude and longitude coordinates) and speed information included in PVD data of a C-ITS equipped vehicle. At this time, a transmission period of the PVD data is 1 second, which may be longer than a period of updating a vehicle state in simulation information (e.g., 0.01 to 0.1 seconds). At this time, the electronic device 100 may generate simulation information by estimating a position and a speed of a vehicle according to a vehicle state update period of the simulation information based on the PVD data. The electronic device 100 may estimate the position and speed of the vehicle using a Kalman filter. The Kalman filter is a type of estimation algorithm and may mean an algorithm that predicts a current position of a vehicle at each simulator update period using a mathematical model that predicts a position of a vehicle, and updates an existing mathematical model by comparing a difference between an actual value and a predicted value when next PVD data (an actual value) is received.

Next, the electronic device 100 may place a remaining quantity of vehicles obtained by subtracting the number of reference vehicles (i.e., C-ITS terminal-equipped vehicles) already placed on a corresponding road from a traffic volume of a specific road based on traffic flow data. For example, the electronic device 100 may calculate the total number of vehicles for each lane by using Equation 5 below when acquiring a density of a road as a continuous value, and by using Equation 6 below when using values of smooth, slow, and congested for a road as a discrete value.

## Equation 5

$$n = L \times k$$

Here, L represents a total length of a road, and k represents a density of a lane.

## Equation 6

$$n = L/Vh$$

Here, L represents a total length of a road, V represents a vehicle speed given according to smooth, slow, and congested, and h represents a predetermined headway (e.g., 1 to 2 seconds).

Next, the electronic device 100 calculates a length between reference vehicles placed on the corresponding lane.

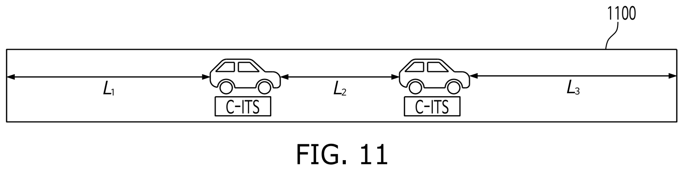

FIG. 11 is a conceptual diagram illustrating reference vehicle placement information 1100 placed on a road in a virtual environment according to an embodiment of the present disclosure. In FIG. 11, it is assumed that two reference vehicles are placed on a road in a virtual environment. At this time, the electronic device 100 may calculate the number of vehicles that should be placed in an individual section using the total number of reference vehicles, the length of each section, and the entire length of the road. Equation 7 exemplarily shows an equation for calculating the number of vehicles for each section.

## Equation 7

$$n_i = L_i/L(n - n_{c-its})$$

Here, $n_i$ represents the number of vehicles in an i-th section, $L_i$ represents a length of the i-th section, L represents a total length of a road, n represents the total number of vehicles on the road, and $n_{c\text{-}its}$ represents the number of reference vehicles placed on the road.

Next, the electronic device 100 calculates an average speed of the remaining vehicles excluding the reference vehicle. Equation 8 exemplarily shows an equation for calculating an average speed of the remaining vehicles excluding the reference vehicle.

Equation 8

$$V_{sur} = \left( Vn - \sum_{j=n_{c-its}} V_{c-its,j} \right) / (n - n_{c-its})$$

Here, $V_{sur}$ represents an average speed of the remaining vehicles excluding the reference vehicles, V represents an average speed of all vehicles, n represents the number of all vehicles, $\sum_{j=nc-its} V_{c-its,j}$ represents a sum of speeds that the reference vehicles each have through PVD data, and $n_{c-its}$ represents the number of reference vehicles.

The electronic device 100 may generate surrounding vehicles on a road in a virtual environment by utilizing the number of vehicles for each section and an average speed of the surrounding vehicles.

In an embodiment, when spawning surrounding vehicles in each section, the electronic device 100 may spawn surrounding vehicles of a plurality of vehicle types based on traffic volume information by vehicle type included in the traffic flow data 120. Specifically, the electronic device 100 may spawn surrounding vehicles in various ways according to a ratio of each vehicle type included in the traffic flow data. For example, let's assume that a vehicle type ratio of a specific road included in the traffic flow data is 1:1:2 (in order, quantity of type 1 : quantity of type 2 : quantity of type 3), and the number of surrounding vehicles that should be placed in the corresponding section is 40. At this time, the electronic device 100 may generate more realistic simulation information by spawning 10 type 1 vehicles, 10 type 2 vehicles, and 20 type 3 vehicles to be evenly distributed, instead of spawning surrounding vehicles as 40 single vehicles.

As described above, the present disclosure may generate traffic flow simulation information that is more similar to realistic vehicle behavior by using a real-time position of a C-ITS terminal-equipped vehicle through PVD data and generating surrounding vehicles based on the real-time position. In addition, the present disclosure may generate simulation information that better reflects real information by generating simulation information in consideration of vehicle types.

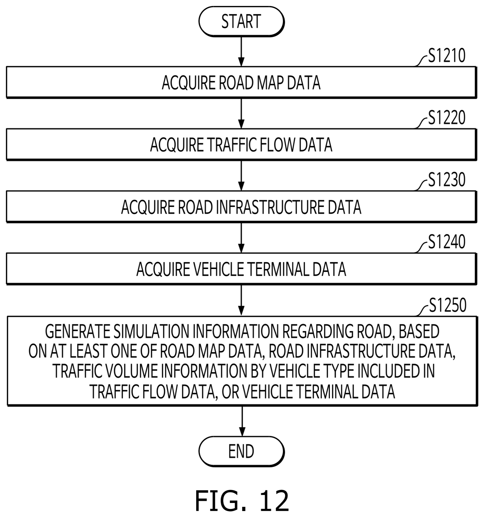

FIG. 12 is a diagram for explaining a method of providing simulation information according to an embodiment of the present disclosure. Referring to FIG. 12, a processor of an electronic device (e.g., the electronic device 100 of FIG. 1) may acquire road map data (e.g., the road map data 110 of FIG. 1) in step S1210. Here, the road map data represents data in which each of a plurality of lanes included in a road is represented by a node and a link connected from the node, and the road map data may, for example, include road map data distributed by the National Geographic Information Institute (NGII).

In step S1220, the processor may acquire traffic flow data (e.g., the traffic flow data 120 of FIG. 1). Here, the traffic flow data may be a continuous value such as the number of passing vehicles per unit time, an average speed of vehicles, traffic volume, and density, or a combination thereof.

In step S1230, the processor may acquire road infrastructure data (e.g., the road infrastructure data 140 of FIG. 1). Here, the road infrastructure data may include SPaT data, MAP data, RSA data, and/or TIM data.

In step S1240, the processor may acquire vehicle terminal data (e.g., the vehicle terminal data 130 of FIG. 1). Here, the vehicle terminal data may be data including PVD data.

In step S1250, the processor may generate simulation information based on at least one of the road map data, the road infrastructure data, traffic volume information by vehicle type included in the traffic flow data, or the vehicle terminal data.

The above-described flowchart and the above-described description are only an example, and may be implemented differently in some embodiments. For example, in some embodiments, an order of each step may be changed, some steps may be repeatedly performed, some steps may be omitted, or some steps may be added.

The above-described method may be provided as a computer program stored in a computer-readable recording medium for execution on a computer. The medium may continuously store a computer-executable program, or may temporarily store the computer-executable program for execution or download. In addition, the medium may be various recording means or storage means in the form of a single hardware or a combination of several hardwares, and is not limited to a medium that is directly connected to a certain computer system, but may be distributed on a network. Examples of the medium may include a magnetic medium such as a hard disk, a floppy disk, and a magnetic tape, an optical recording medium such as a CD-ROM and a DVD, a magnetooptical medium such as a floptical disk, and a medium configured to store program instructions, including a ROM, a RAM, a flash memory, and the like. In addition, as another example of the medium, a recording medium or a storage medium managed by an app store that distributes applications or a site, a server, etc. that supplies or distributes various other software may also be included.

The methods, operations, or techniques of the present disclosure may also be implemented by various means. For example, these techniques may be implemented in hardware, firmware, software, or a combination thereof. Those of ordinary skill in the art will understand that the various exemplary logical blocks, modules, circuits, and algorithm steps described in connection with the disclosure herein may be implemented as electronic hardware, computer software, or combinations of both. To clearly illustrate this interchangeability of hardware and software, various exemplary components, blocks, modules, circuits, and steps have been described above generally in terms of their functionality. Whether such functionality is implemented as hardware or software depends upon the particular application and design constraints imposed on the overall system. A person of ordinary skill in the art may implement the described functionality in varying ways for each particular application, but such implementation decisions should not be interpreted as causing a departure from the scope of the present disclosure.

In a hardware implementation, processing units used to perform the techniques may be implemented within one or more ASICs, DSPs, digital signal processing devices (DSPDs), programmable logic devices (PLDs), field programmable gate arrays (FPGAs), processors, controllers, microcontrollers, microprocessors, electronic devices, other electronic units designed to perform the functions described in the present disclosure, a computer, or a combination thereof.

Accordingly, the various exemplary logical blocks, modules, and circuits described in connection with the present disclosure may be implemented or performed with a general-purpose processor, a DSP, an ASIC, an FPGA or other programmable logic device, discrete gate or transistor logic, discrete hardware components, or any combination thereof designed to perform the functions described herein. A general-purpose processor may be a microprocessor, but in the alternative, the processor may be any conventional processor, controller, microcontroller, or state machine. A processor may also be implemented as a combination of computing devices, e.g., a combination of a DSP and a microprocessor, a plurality of microprocessors, one or more microprocessors in conjunction with a DSP core, or any other such configuration.

In a firmware and/or software implementation, the techniques may be implemented as instructions stored on a computer-readable medium, such as random access memory (RAM), read-only memory (ROM), non-volatile random access memory (NVRAM), programmable read-only memory (PROM), erasable programmable read-only memory (EPROM), electrically erasable PROM (EEPROM), flash memory, a compact disc (CD), a magnetic or marking data storage device, and the like. The instructions may be executable by one or more processors and may cause the processor(s) to perform certain aspects of the functionality described in the present disclosure.

When implemented in software, the techniques described above may be stored on or transmitted over as one or more instructions or code on a computer-readable medium. Computer-readable media include both computer storage media and communication media including any medium that facilitates transfer of a computer program from one place to another. A storage media may be any available media that can be accessed by a computer. By way of example, and not limitation, such computer-readable media can comprise RAM, ROM, EEPROM, CD-ROM or other optical disk storage, magnetic disk storage or other magnetic storage devices, or any other medium that can be used to carry or store desired program code in the form of instructions or data structures and that can be accessed by a computer. Also, any connection is properly termed a computer-readable medium.

For example, if the software is transmitted from a website, server, or other remote source using a coaxial cable, fiber optic cable, twisted pair, digital subscriber line (DSL), or wireless technologies such as infrared, radio, and microwave, then the coaxial cable, fiber optic cable, twisted pair, DSL, or wireless technologies such as infrared, radio, and microwave are included in the definition of medium. Disk and disc, as used herein, includes a CD, a laser disc, an optical disc, a digital versatile disc (DVD), a floppy disk, and a Blu-ray disc where disks usually reproduce data magnetically, while discs reproduce data optically with lasers. Combinations of the above should also be included within the scope of computer-readable media.

A software module may reside in a RAM memory, a flash memory, a ROM memory, an EPROM memory, an EEPROM memory, registers, a hard disk, a removable disk, a CD-ROM, or any other form of storage medium known in the art. An exemplary storage medium may be coupled to a processor such that the processor can read information from, and write information to, the storage medium. In the alternative, the storage medium may be integral to the processor. The processor and the storage medium may reside in an ASIC. The ASIC may reside in a user terminal. In the alternative, the processor and the storage medium may reside as discrete components in a user terminal.

Although the above-described embodiments have been described as utilizing aspects of the presently disclosed subject matter in one or more standalone computer systems, the present disclosure is not limited thereto, and may be implemented in connection with any computing environment, such as a network or a distributed computing environment. Further, aspects of the subject matter in the present disclosure may be implemented in a plurality of processing chips or devices, and storage may be similarly affected across a plurality of devices. Such devices may include PCs, network servers, and portable devices.

In this specification, although the present disclosure has been described in relation to some embodiments, various modifications and changes may be made without departing from the scope of the present disclosure, which can be understood by a person of ordinary skill in the art to which the invention of the present disclosure pertains. In addition, such modifications and changes should be considered to fall within the scope of the claims attached to this specification.

**Claims**

1. A method performed by at least one processor of an apparatus, the method comprising:

   acquiring road map data comprising information regarding each of one or more lanes included in a road section of a road;
   acquiring traffic flow data corresponding to the road section, wherein the traffic flow data comprises traffic volume information by vehicle type;
   acquiring road infrastructure data associated with the road section;
   acquiring vehicle terminal data from at least one vehicle located on the road section;
   generating simulation information regarding the road, based on at least one of the road map data, the road infrastructure data, the traffic volume information, and the vehicle terminal data; and
   causing at least one of the apparatus or a simulation device to perform, based on the simulation information, a vehicle driving simulation.

2. The method as claimed in claim 1, further comprising:

   acquiring a wheelbase distance by vehicle type or length information by vehicle type,
   wherein the generating the simulation information is performed based on at least one of the wheelbase distance or the length information.

3. The method as claimed in claim 2, further comprising:

   determining an inter-vehicle distance based on the vehicle terminal data,
   wherein the inter-vehicle distance is determined further based on an average distance for each vehicle type.

4. The method as claimed in claim 1,

   wherein the road infrastructure data comprises:

      signal phase and timing operation information, and
      map data, and

   the generating the simulation information comprises:

      mapping the map data to the road map data and generating a virtual road in a virtual environment;
      identifying a specific intersection existing on the virtual road in the virtual environment;
      identifying the identified specific intersection in the signal phase and timing operation information; and
      applying a signal state of the specific intersection to the virtual road in the virtual environment based on the signal phase and timing operation information.

5. The method as claimed in claim 4, wherein:

   the signal phase and timing operation information comprises a unique number of an intersection and a plurality of pieces of movement state information,
   the movement state information comprises a signal group identifier, a plurality of signal states, and remaining time information until each of the plurality of signal states changes to a next signal state,
   the map data comprises a unique number of an intersection, reference point information, and one or more pieces of lane information,
   the lane information comprises offset point information determined based on the reference point information, a signal group identifier verifiable in a lane, lane information connected to the lane, and entry/exit attribute information of the lane, and
   the identifying the specific intersection comprises:
   matching map data having a same signal group identifier to a signal group identifier included in the signal phase and timing operation information.

6. The method as claimed in claim 1,
   wherein the generating the simulation information comprises:

placing a reference vehicle on a virtual road in a virtual environment;

determining a number of surrounding vehicles, excluding the reference vehicle, among all vehicles to be placed on the virtual road; and

distributing and placing the surrounding vehicles for each section on the virtual road divided by the reference vehicle.

7. The method as claimed in claim 6,
wherein the generating the simulation information further comprises:

determining a speed of the surrounding vehicles, excluding the reference vehicle, among all the vehicles to be placed on the virtual road,

the determining the speed of the surrounding vehicles comprises:

determining an average speed of the surrounding vehicles, excluding the reference vehicle, among all the vehicles.

8. The method as claimed in claim 6,
wherein the distributing and placing the surrounding vehicles comprises:

determining a ratio by vehicle type based on traffic volume information included in the traffic flow data; and

distributing and placing the surrounding vehicles according to the determined ratio.

9. A non-transitory computer-readable recording medium storing computer-readable instructions that, when executed by at least one processor of an apparatus, cause the apparatus to:

acquire road map data comprising information regarding each of one or more lanes included in a road section of a road,

acquire traffic flow data corresponding to the road section, wherein the traffic flow data comprises traffic volume information by vehicle type,

acquire road infrastructure data associated with the road section,

acquire vehicle terminal data from at least one vehicle located on the road section,

generate simulation information regarding the road, based on at least one of the road map data, the road infrastructure data, the traffic volume information, and the vehicle terminal data, and

cause at least one of the apparatus or a simulation device to perform, based on the simulation information, a vehicle driving simulation.

10. An apparatus, comprising:

a memory; and

at least one processor coupled to the memory and configured to execute at least one computer-readable instruction stored in the memory,

wherein the at least one processor is configured to:

acquire road map data comprising information regarding each of one or more lanes included in a road section of a road,

acquire traffic flow data corresponding to the road section, wherein the traffic flow data comprises traffic volume information by vehicle type,

acquire road infrastructure data associated with the road section,

acquire vehicle terminal data from at least one vehicle located on the road section,

generate simulation information regarding the road, based on at least one of the road map data, the road infrastructure data, the traffic volume information, and the vehicle terminal data, and

cause at least one of the apparatus or a simulation device to perform, based on the simulation information, a vehicle driving simulation.

TRAFFIC FLOW DATA
120

ROAD MAP DATA
110

VEHICLE TERMINAL DATA
130

ROAD INFRASTRUCTURE DATA
140

ELECTRONIC DEVICE
100

SIMULATION INFORMATION
150

FIG. 1

FIG. 2

USER TERMINAL 210

MEMORY 312

INPUT AND OUTPUT INTERFACE 318

PROCESSOR 314

COMMUNICATION MODULE 316

INPUT AND OUTPUT DEVICE 320

NETWORK 220

INFORMATION PROCESSING SYSTEM 230

MEMORY 332

INPUT AND OUTPUT INTERFACE 338

PROCESSOR 334

COMMUNICATION MODULE 336

FIG. 3

EP 4 738 307 A1

400

| | A | B | C | D | E | F | G | H | A | J |
|---|---|---|---|---|---|---|---|---|---|---|
| | DATE | DAY | POINT NAME | POINT NUMBER | DIRECTION | CLASSIFICATION | 00:00 | 01:00 | 02:00 | 03:00 |
| 1 | 20240101 | SUN | SEONGSAN-RO (GEUMHWA TUNNEL) | A-01 | INFLOW | BONGWON OVERPASS-)DONGNIMMUN STATION | 527 | 456 | 302 | 179 |
| 2 | 20240102 | MON | SEONGSAN-RO (GEUMHWA TUNNEL) | A-01 | INFLOW | BONGWON OVERPASS-)DONGNIMMUN STATION | 251 | 168 | 143 | 120 |
| 3 | 20240103 | TUE | SEONGSAN-RO (GEUMHWA TUNNEL) | A-01 | INFLOW | BONGWON OVERPASS-)DONGNIMMUN STATION | 456 | 289 | 207 | 173 |
| 4 | 20240104 | WED | SEONGSAN-RO (GEUMHWA TUNNEL) | A-01 | INFLOW | BONGWON OVERPASS-)DONGNIMMUN STATION | 442 | 341 | 251 | 175 |
| 5 | 20240105 | THU | SEONGSAN-RO (GEUMHWA TUNNEL) | A-01 | INFLOW | BONGWON OVERPASS-)DONGNIMMUN STATION | 519 | 374 | 294 | 212 |
| 6 | 20240106 | FRI | SEONGSAN-RO (GEUMHWA TUNNEL) | A-01 | INFLOW | BONGWON OVERPASS-)DONGNIMMUN STATION | 529 | 429 | 338 | 280 |
| 7 | 20240107 | SAT | SEONGSAN-RO (GEUMHWA TUNNEL) | A-01 | INFLOW | BONGWON OVERPASS-)DONGNIMMUN STATION | 318 | 230 | 194 | 152 |
| 8 | 20240108 | SUN | SEONGSAN-RO (GEUMHWA TUNNEL) | A-01 | INFLOW | BONGWON OVERPASS-)DONGNIMMUN STATION | 287 | 192 | 172 | 165 |
| 9 | 20240109 | MON | SEONGSAN-RO (GEUMHWA TUNNEL) | A-01 | INFLOW | BONGWON OVERPASS-)DONGNIMMUN STATION | 493 | 303 | 255 | 187 |
| 10 | 20240110 | TUE | SEONGSAN-RO (GEUMHWA TUNNEL) | A-01 | INFLOW | BONGWON OVERPASS-)DONGNIMMUN STATION | 382 | 287 | 224 | 164 |
| 11 | 20240111 | WED | SEONGSAN-RO (GEUMHWA TUNNEL) | A-01 | INFLOW | BONGWON OVERPASS-)DONGNIMMUN STATION | 492 | 374 | 240 | 206 |
| 12 | 20240112 | THU | SEONGSAN-RO (GEUMHWA TUNNEL) | A-01 | INFLOW | BONGWON OVERPASS-)DONGNIMMUN STATION | 543 | 402 | 276 | 206 |
| 13 | 20240113 | FRI | SEONGSAN-RO (GEUMHWA TUNNEL) | A-01 | INFLOW | BONGWON OVERPASS-)DONGNIMMUN STATION | 556 | 416 | 327 | 282 |
| 14 | 20240114 | SAT | SEONGSAN-RO (GEUMHWA TUNNEL) | A-01 | INFLOW | BONGWON OVERPASS-)DONGNIMMUN STATION | 388 | 315 | 251 | 181 |
| 15 | 20240115 | SUN | SEONGSAN-RO (GEUMHWA TUNNEL) | A-01 | INFLOW | BONGWON OVERPASS-)DONGNIMMUN STATION | 285 | 180 | 154 | 149 |
| 16 | 20240116 | MON | SEONGSAN-RO (GEUMHWA TUNNEL) | A-01 | INFLOW | BONGWON OVERPASS-)DONGNIMMUN STATION | 431 | 316 | 224 | 172 |
| 17 | 20240117 | TUE | SEONGSAN-RO (GEUMHWA TUNNEL) | A-01 | INFLOW | BONGWON OVERPASS-)DONGNIMMUN STATION | 549 | 356 | 240 | 184 |
| 18 | 20240118 | WED | SEONGSAN-RO (GEUMHWA TUNNEL) | A-01 | INFLOW | BONGWON OVERPASS-)DONGNIMMUN STATION | 391 | 307 | 262 | 199 |
| 19 | 20240119 | THU | SEONGSAN-RO (GEUMHWA TUNNEL) | A-01 | INFLOW | BONGWON OVERPASS-)DONGNIMMUN STATION | 574 | 404 | 321 | 206 |
| 20 | 20240120 | FRI | SEONGSAN-RO (GEUMHWA TUNNEL) | A-01 | INFLOW | BONGWON OVERPASS-)DONGNIMMUN STATION | 516 | 422 | 313 | 272 |
| 21 | 20240121 | SAT | SEONGSAN-RO (GEUMHWA TUNNEL) | A-01 | INFLOW | BONGWON OVERPASS-)DONGNIMMUN STATION | 388 | 288 | 253 | 165 |

FIG. 4

| ROUTE NAME | POINT NUMBER | START POINT | END POINT | YEAR | MONTH | DAY | HOUR | DIRECTION | TYPE 1 | TYPE 2 | TYPE 3 | TYPE 4 | TYPE 5 | TYPE 6 | TYPE 7 | TYPE 8 |
|---|---|---|---|---|---|---|---|---|---|---|---|---|---|---|---|---|
| GYEONGBU LINE | 00134-1 | DONGTAN JCT | GIHEUNG IC | 2023 | 10 | 19 | 0 | 1 | 992 | 24 | 137 | 101 | 110 | 26 | 33 | 0 |
| GYEONGBU LINE | 00134-1 | DONGTAN JCT | GIHEUNG IC | 2023 | 10 | 19 | 0 | 1 | 820 | 50 | 119 | 105 | 136 | 53 | 25 | 0 |
| GYEONGBU LINE | 00134-1 | DONGTAN JCT | GIHEUNG IC | 2023 | 10 | 19 | 0 | 1 | 602 | 17 | 161 | 136 | 108 | 25 | 24 | 0 |
| GYEONGBU LINE | 00134-1 | DONGTAN JCT | GIHEUNG IC | 2023 | 10 | 19 | 0 | 1 | 460 | 13 | 129 | 135 | 119 | 63 | 13 | 0 |
| GYEONGBU LINE | 00134-1 | DONGTAN JCT | GIHEUNG IC | 2023 | 10 | 19 | 0 | 1 | 412 | 9 | 148 | 177 | 140 | 37 | 33 | 0 |
| GYEONGBU LINE | 00134-1 | DONGTAN JCT | GIHEUNG IC | 2023 | 10 | 19 | 0 | 1 | 378 | 4 | 131 | 160 | 94 | 41 | 16 | 0 |
| GYEONGBU LINE | 00134-1 | DONGTAN JCT | GIHEUNG IC | 2023 | 10 | 19 | 0 | 1 | 390 | 6 | 149 | 152 | 211 | 51 | 64 | 0 |
| GYEONGBU LINE | 00134-1 | DONGTAN JCT | GIHEUNG IC | 2023 | 10 | 19 | 0 | 1 | 372 | 9 | 167 | 142 | 102 | 19 | 22 | 0 |
| GYEONGBU LINE | 00134-1 | DONGTAN JCT | GIHEUNG IC | 2023 | 10 | 19 | 0 | 1 | 548 | 25 | 178 | 203 | 232 | 75 | 101 | 0 |
| GYEONGBU LINE | 00134-1 | DONGTAN JCT | GIHEUNG IC | 2023 | 10 | 19 | 0 | 1 | 885 | 26 | 289 | 187 | 149 | 35 | 50 | 0 |
| GYEONGBU LINE | 00134-1 | DONGTAN JCT | GIHEUNG IC | 2023 | 10 | 19 | 0 | 1 | 1443 | 46 | 369 | 319 | 341 | 85 | 152 | 0 |
| GYEONGBU LINE | 00134-1 | DONGTAN JCT | GIHEUNG IC | 2023 | 10 | 19 | 0 | 1 | 2592 | 43 | 642 | 296 | 211 | 55 | 63 | 0 |
| GYEONGBU LINE | 00134-1 | DONGTAN JCT | GIHEUNG IC | 2023 | 10 | 19 | 0 | 1 | 2791 | 121 | 532 | 265 | 255 | 37 | 47 | 0 |
| GYEONGBU LINE | 00134-1 | DONGTAN JCT | GIHEUNG IC | 2023 | 10 | 19 | 0 | 1 | 4453 | 313 | 932 | 322 | 190 | 34 | 41 | 0 |
| GYEONGBU LINE | 00134-1 | DONGTAN JCT | GIHEUNG IC | 2023 | 10 | 19 | 0 | 1 | 3261 | 287 | 385 | 158 | 116 | 36 | 32 | 0 |
| GYEONGBU LINE | 00134-1 | DONGTAN JCT | GIHEUNG IC | 2023 | 10 | 19 | 0 | 1 | 5093 | 556 | 583 | 159 | 91 | 33 | 37 | 0 |
| GYEONGBU LINE | 00134-1 | DONGTAN JCT | GIHEUNG IC | 2023 | 10 | 19 | 0 | 1 | 3705 | 269 | 418 | 145 | 95 | 30 | 24 | 0 |
| GYEONGBU LINE | 00134-1 | DONGTAN JCT | GIHEUNG IC | 2023 | 10 | 19 | 0 | 1 | 4567 | 461 | 373 | 149 | 91 | 28 | 35 | 0 |
| GYEONGBU LINE | 00134-1 | DONGTAN JCT | GIHEUNG IC | 2023 | 10 | 19 | 0 | 1 | 3278 | 350 | 390 | 176 | 122 | 34 | 24 | 0 |
| GYEONGBU LINE | 00134-1 | DONGTAN JCT | GIHEUNG IC | 2023 | 10 | 19 | 0 | 1 | 4121 | 356 | 358 | 162 | 122 | 34 | 49 | 0 |
| GYEONGBU LINE | 00134-1 | DONGTAN JCT | GIHEUNG IC | 2023 | 10 | 19 | 0 | 1 | 3029 | 264 | 443 | 171 | 126 | 24 | 25 | 0 |
| GYEONGBU LINE | 00134-1 | DONGTAN JCT | GIHEUNG IC | 2023 | 10 | 19 | 0 | 1 | 3889 | 269 | 377 | 143 | 128 | 32 | 36 | 0 |
| GYEONGBU LINE | 00134-1 | DONGTAN JCT | GIHEUNG IC | 2023 | 10 | 19 | 0 | 1 | 3139 | 264 | 442 | 221 | 132 | 36 | 46 | 0 |
| GYEONGBU LINE | 00134-1 | DONGTAN JCT | GIHEUNG IC | 2023 | 10 | 19 | 0 | 1 | 4023 | 265 | 467 | 155 | 160 | 49 | 32 | 0 |

500

FIG. 5

EP 4 738 307 A1

600

| VEHICLE CLASSIFICATION TABLE | | | |
|---|---|---|---|
| 11-TYPE VEHICLE CLASSIFICATION TABLE | | ROAD TRAFFIC VOLUME SURVEY)VEHICLE CLASSIFICATION TABLE)11-TYPE VEHICLE CLASSIFICATION TABLE | |
| TYPE | TYPE 1 | PASSENGER CARS AND SMALL BUSES | |
| CLASSIFICATION CRITERIA | NUMBER OF AXLES (AXLE)2   NUMBER OF WHEELS (WHEEL)4 | UNIT (EA)1 | WHEELBASE (mm) ≤ 2,800 |
| REPRESENTATIVE BODY AND AXLE LAYOUT | | | |
| VEHICLE DEFINITION | 2-AXLE, 4-WHEEL SEDANS AND WAGONS FOR PASSENGER TRANSPORT; INCLUDES SMALL FREIGHT VEHICLES LIKE MINI TRUCKS | | |
| EXAMPLES OF CORRESPONDING VEHICLES | ACCENT, AVANTE, AVANTE XG, TIBURON, MAGNUS, GRACE, STAREX, ATOS, VERNA (OLD MODEL), TICO, LE MANS, NEXIA, CIELO, LANOS, ESPERO, NUBIRA, SUPER SALON, PRINCE, ARCADIA, DAMAS, LABO, LEGANZA, MATIZ (DAEWOO), VISTO, PRIDE, AVELLA, CARENS, CAPITAL, CONCORD, SEPHIA, CREDOS, CARNIVAL, ELAN, SABLE, POTENTIA, SPORTAGE, BONGO, PREGIO, TOWNER, ROCSTA, SHUMA, CARNIVAL, ELAN, ENTERPRISE (KIA), KORANDO, MUSSO, ISTANA (OLD MODEL) | | |
| TYPE | TYPE 2 | MEDIUM-SIZED BUS | |
| CLASSIFICATION CRITERIA | NUMBER OF AXLES (AXLE)2  NUMBER OF WHEELS (WHEEL)4/6 | UNIT (EA)1 | WHEELBASE (mm) 2,800~3,500 |
| REPRESENTATIVE BODY AND AXLE LAYOUT | | | |
| VEHICLE DEFINITION | VAN OR BUS TYPE FOR PASSENGER TRANSPORT; SINGLE-UNIT VEHICLE WITH 2-AXLE, 4 OR 6-WHEEL STRUCTURE, SEATING 25 OR FEWER PASSENGERS | | |
| EXAMPLES OF CORRESPONDING VEHICLES | CHORUS (OLD MODEL), HI-TOPIC (UP TO 15-SEATER), NEW COMBI (UP TO 25-SEATER) (ASIA MOTORS), GRACE (15-SEATER), BONGO (15-SEATER) | | |
| TYPE | TYPE3 | LARGE-SIZED BUS | |
| CLASSIFICATION CRITERIA | NUMBER OF AXLES (AXLE)2   NUMBER OF WHEELS (WHEEL)6 | UNIT (EA)1 | WHEELBASE (mm) 3,500~6,500 |
| REPRESENTATIVE BODY AND AXLE LAYOUT | | | |
| VEHICLE DEFINITION | MEDIUM-SIZED BUS FOR PASSENGER TRANSPORT; SINGLE-UNIT VEHICLE WITH 2-AXLE, 6-WHEEL STRUCTURE, SEATING 25 OR MORE PASSENGERS | | |
| EXAMPLES OF CORRESPONDING VEHICLES | AERO (EXPRESS), AERO BUS (CURRENT), CITY BUS, EXPRESS BUS, TOUR BUS, SEATED BUS, ROYAL BUS (DAEWOO), SUPER BUS (OLD MODEL), COSMOS (25-SEATER AND OVER), INTERCITY BUS, CHARTER BUS (ASIA MOTORS) | | |

FIG. 6

Offset List

| (x1,y1) | (x2,y2) | (x3,y3) | (x4,y3) | (x5,y5) | (x6,y6) | (x7,y7) |

710

mimnum : 2 maximum : 63

FIG. 7

FIG. 8

FIG. 9

FIG. 10

1100

$L_1$ C-ITS $L_2$ C-ITS $L_3$

FIG. 11

START

ACQUIRE ROAD MAP DATA ⟋S1210

ACQUIRE TRAFFIC FLOW DATA ⟋S1220

ACQUIRE ROAD INFRASTRUCTURE DATA ⟋S1230

ACQUIRE VEHICLE TERMINAL DATA ⟋S1240

GENERATE SIMULATION INFORMATION REGARDING ROAD, BASED ON AT LEAST ONE OF ROAD MAP DATA, ROAD INFRASTRUCTURE DATA, TRAFFIC VOLUME INFORMATION BY VEHICLE TYPE INCLUDED IN TRAFFIC FLOW DATA, OR VEHICLE TERMINAL DATA ⟋S1250

END

FIG. 12

## EUROPEAN SEARCH REPORT

**Application Number**

EP 25 21 1261

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KR 102 679 822 B1 (THE KOREA TRANSP INSTITUTE [KR]) 1 July 2024 (2024-07-01)<br>* paragraphs [0008], [0009] *<br>* paragraph [0015] *<br>* paragraphs [0035], [0036] *<br>* paragraphs [0050], [0051] *<br>* paragraphs [0054], [0055] *<br>* paragraphs [0061], [0062] *<br>----- | 1-10 | INV.<br>G08G1/01 |
| X | JP 2014 170290 A (SUMITOMO ELECTRIC SYSTEM SOLUTIONS CO LTD)<br>18 September 2014 (2014-09-18)<br>* paragraph [0031] *<br>* paragraph [0038] *<br>* paragraphs [0040], [0041] *<br>* paragraphs [0044] - [0046] *<br>* paragraph [0074] *<br>----- | 1-10 | |
| A | CN 113 380 035 B (SHANDONG PROVINCIAL COMMUNICATIONS PLANNING AND DESIGN INST GROUP CO L) 11 November 2022 (2022-11-11)<br>* the whole document *<br>----- | 1-10 | **TECHNICAL FIELDS SEARCHED (IPC)**<br><br>G08G |
| A | WO 2023/049453 A1 (GRIDMATRIX INC [US])<br>30 March 2023 (2023-03-30)<br>* the whole document *<br>----- | 1-10 | |
| A | JP 6 896374 B2 (TOSHIBA CORP)<br>30 June 2021 (2021-06-30)<br>* the whole document *<br>----- | 1-10 | |
| A | US 2011/035146 A1 (TELCORDIA TECH INC [US]) 10 February 2011 (2011-02-10)<br>* the whole document *<br>----- | 1-10 | |
| A | CN 117 671 948 A (TENCENT TECH SHENZHEN CO LTD) 8 March 2024 (2024-03-08)<br>* the whole document *<br>----- | 1-10 | |

The present search report has been drawn up for all claims

| Place of search | Date of completion of the search | Examiner |
|---|---|---|
| The Hague | 23 February 2026 | de la Cruz Valera, D |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

                             

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 21 1261

This annex lists the patent family members relating to the patent documents cited in the above-mentioned European search report.
The members are as contained in the European Patent Office EDP file on
The European Patent Office is in no way liable for these particulars which are merely given for the purpose of information.

23-02-2026

| Patent document cited in search report | | Publication date | Patent family member(s) | | Publication date |
|---|---|---|---|---|---|
| KR 102679822 | B1 | 01-07-2024 | NONE | | |
| JP 2014170290 | A | 18-09-2014 | JP | 6139179 B2 | 31-05-2017 |
| | | | JP | 2014170290 A | 18-09-2014 |
| CN 113380035 | B | 11-11-2022 | NONE | | |
| WO 2023049453 | A1 | 30-03-2023 | NONE | | |
| JP 6896374 | B2 | 30-06-2021 | JP | 6896374 B2 | 30-06-2021 |
| | | | JP | 2017194913 A | 26-10-2017 |
| US 2011035146 | A1 | 10-02-2011 | EP | 2473820 A1 | 11-07-2012 |
| | | | JP | 5602856 B2 | 08-10-2014 |
| | | | JP | 2013501938 A | 17-01-2013 |
| | | | US | 2011035146 A1 | 10-02-2011 |
| | | | WO | 2011019627 A1 | 17-02-2011 |
| CN 117671948 | A | 08-03-2024 | NONE | | |

EPO FORM P0459

For more details about this annex : see Official Journal of the European Patent Office, No. 12/82